# EUROPEAN PATENT APPLICATION

(11) **EP 1 041 640 A2**
(43) Date of publication of application: **04.10.2000**
(21) Application number: 00104705.9
(22) Date of filing: 03.03.2000
(51) Int. Cl.: H01L 29/78, H01L 21/336

(54) **Power trench MOS-gated device and method of manufacturing it**

(30) Priority: 01.04.1999 US 283536
(71) Applicant: Intersil Corporation, Palm Bay, Florida 32904 (US)
(72) Inventor: Kocon, Christopher, Plains, PA 18705 (US)
(74) Representative: Meddle, Alan Leonard

(57) **Abstract**

A power trench MOS-gated device includes a heavily doped semiconductor substrate, a doped upper layer of a first conduction type on the substrate, and a trench gate in the upper layer that comprises a conductive material separated from the upper layer by an insulating layer. An enhanced conductivity drain region underlies the trench gate, and a heavily doped source region of the first conduction type and a heavily doped body region of a second and opposite conduction type are disposed at an upper surface of the upper layer. A deep well region of the second conduction type underlies the source and body regions and extends below the trench gate and abuts the enhanced conductivity drain region. A process for forming a power trench MOS-gated device comprises providing a semiconductor substrate having a doped upper layer of a first conduction type. A dopant of a second and opposite conduction type is implanted into an upper surface of the upper layer, thereby forming a well region in the upper layer, and a layer of nitride is deposited on the upper surface. The nitride layer and upper layer are selectively etched to form a trench in the upper layer. The sidewalls and floor of the trench are lined with a thin insulating layer, and a dopant of the first conduction type is implanted through the thin insulating layer on the trench floor, thereby forming an enhanced conductivity drain region in the upper layer underlying the trench floor. The thin insulating layer is removed from the trench, and a layer of gate insulating material is formed on the sidewalls and floors of the trench, which is then substantially filled with a conductive material to form a trench gate. The nitride layer is removed from the upper surface of the upper layer, and the well region in the upper layer is thermally diffused, thereby forming a deep well region in the upper layer.

## Description

The present invention relates to MOS devices and, more particularly, to a power trench MOS-gated device and to a process for forming same.

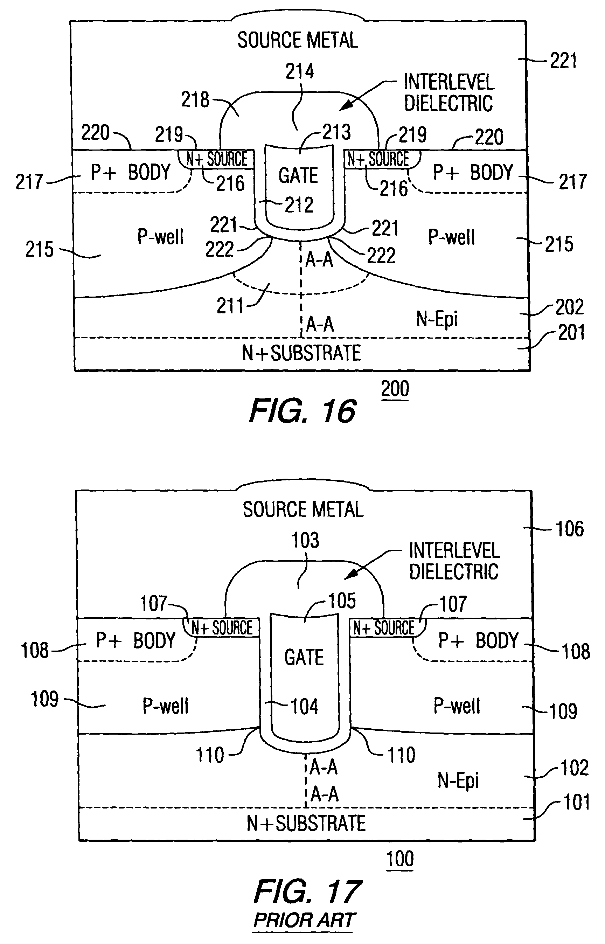

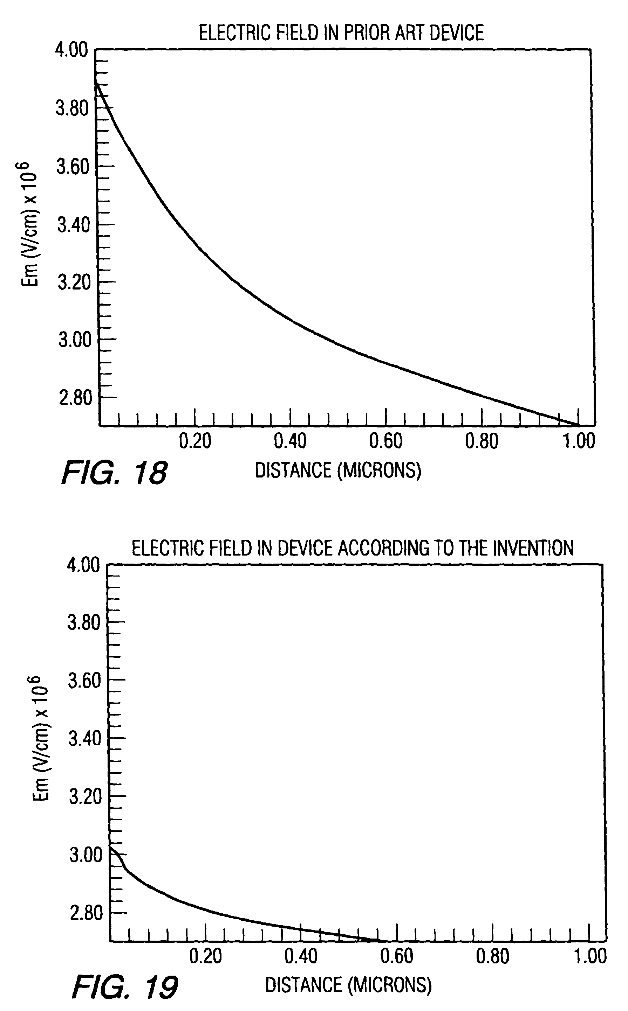

FIG. 17 is a schematic cross-sectional representation of a known trench-gated MOSFET device 100 on an N+ substrate 101 having an upper epitaxial layer 102. A trench gate 103 that includes a trench that has gate dielectric 104 located on its sidewalls and is filled with doped polysilicon 105 serving as a gate electrode. Source connection is achieved through a top metal 106 connected to source and body regions 107 and 108, respectively, located in P-well regions 109. The back side of substrate 101 is used as a drain. Although FIG. 18 shows only one MOSFET, a typical device consists of an array of them arranged in various cellular or stripe layouts currently used by the industry.

The present invention is directed to a power trench MOS-gated device that includes a heavily doped semiconductor substrate, a doped upper layer of a first conduction type on the substrate, and a trench gate in the upper layer that comprises a conductive material separated from the upper layer by an insulating layer. An enhanced conductivity drain region underlies the trench gate, and a heavily doped source region of the first conduction type and a heavily doped body region of a second and opposite conduction type are disposed at an upper surface of the upper layer. A deep well region of the second conduction type underlies the source and body regions and extends below the trench gate and abuts the enhanced conductivity drain region.

The present invention includes a power trench MOS-gated device comprising a heavily doped semiconductor substrate, a doped upper layer of a first conduction type disposed on said substrate, a trench gate disposed in said upper layer, said gate comprising a conductive material separated from said upper layer by an insulating layer, an enhanced conductivity drain region underlying said trench gate in said upper layer, characterized in that a heavily doped source region of said first conduction type and a heavily doped body region of a second and opposite conduction type disposed at an upper surface of said upper layer, a deep well region of said second conduction type disposed in said upper layer underlying said source and body regions, said deep well region extending below said trench gate and abutting said enhanced conductivity drain region, in which said enhanced conductivity drain region is more heavily doped than said doped upper layer.

The invention also includes process for forming a power trench MOS-gated device, said process comprising providing a semiconductor substrate comprising a doped upper layer of a first conduction type, said upper layer having an upper surface, implanting a dopant of a second and opposite conduction type into said upper surface, so as to form a well region in said upper layer, forming a layer of nitride on said upper surface of said upper layer, selectively etching said nitride layer and said upper layer, thereby forming a trench in said upper layer, lining sidewalk and floor of said trench with a thin insulating layer, characterized by implanting a dopant of said first conduction type through the trench floor, thereby forming an enhanced conductivity drain region underlying said trench floor, removing said thin insulating layer from said trench, forming a layer of gate insulating material on the sidewalls and floors of the trench, then substantially filling said trench with a conductive material, to form a trench gate, removing said nitride layer from said upper surface of said upper layer, thermally diffusing said well region in said upper layer, to form a deep well region in said upper layer, said deep well region extending below said trench gate and abutting said enhanced conductivity drain region, selectively implanting a dopant of said first conduction type into said upper layer, thereby forming a heavily doped source region adjacent to said gate trench, and selectively implanting a dopant of said second conduction type into said upper layer, to form a heavily doped body region adjacent to said source region.

Advantageously, a process for forming a power trench MOS-gated device that comprises providing a semiconductor substrate having a doped upper layer of a first conduction type. A dopant of a second and opposite conduction type is implanted into an upper surface of the upper layer, thereby forming a well region in the upper layer, and a layer of nitride is deposited on the upper surface.

The nitride layer and upper layer are selectively etched to form a trench in the upper layer. The sidewalls and floor of the trench are lined with an thin insulating layer, and a dopant of the first conduction type is implanted through the thin insulating layer on the trench floor, thereby forming an enhanced conductivity drain region in the upper layer underlying the trench floor. The thin insulating layer is removed from the trench, and a layer of gate insulating material is formed on the sidewalls and floors of the trench, which is then substantially filled with a conductive material to form a trench gate.

The nitride layer is removed from the upper surface of the upper layer, and the well region in the upper layer is thermally diffused, thereby forming a deep well region in the upper layer. The deep well region extends below the trench gate and abuts the enhanced conductivity drain region. A dopant of the first conduction type is selectively implanted into the upper layer to form a heavily doped source region adjacent to the gate trench, and a dopant of the second conduction type is selectively implanted into the upper layer to form a heavily doped body region adjacent to the source region.

The invention will now be described, by way of example, with reference to the accompanying drawings, in which:
FIGS.1-16 schematically depict the steps of forming a a power trench MOS-gated transistor of the present invention,
FIG. 17 is a schematic cross-sectional representation of a known device,
FIGS. 18 and 19 are plots of electric field vs distance for devices of, respectively, the prior art and the present invention; and
FIGS. 20 and 21 are plots illustrating switching loss in devices of, respectively, the prior art and the present invention.

When a known device such as that depicted in FIG. 17 is in a blocking (off) state, a positive voltage is applied to the drain terminal, thereby reverse biasing the P-well and N-drain diode. With no voltage applied to the gate electrode, there is no channel present to allow current to flow between the drain and source electrodes. Since the P-well/N-drain diode is reverse biased, a depletion region containing an electric field is formed. This electric field reaches its maximum at the interface 110 of the silicon of P-well region 109 with the gate oxide 104 at the trench bottom corner. If a large electric field is allowed to build at silicon-oxide interface 110, the oxide becomes charged by carrier injection, making its breakdown voltage unstable and, in extreme cases, destroying the oxide and causing a gate-drain short. In less destructive cases, ionization is localized close to the device channel area, which reduces the high temperature breakdown voltage of the device and decreases its unclamped inductive switching (UIS) capability. Attempts to round the trench corners, as shown in FIG. 17, produce only a small reduction of the electric field.

An additional major factor limiting the use of prior art devices is the switching speed and switching loss associated with them. It is well known that most switching losses in MOSFETs are due to gate/ drain capacitance, also known as Miller capacitance. Since capacitance is directly proportional to the area between the gate and drain at the oxide interface, minimizing it will improve device switching performance. The device of the present invention eliminates both of these shortfalls in prior art devices.

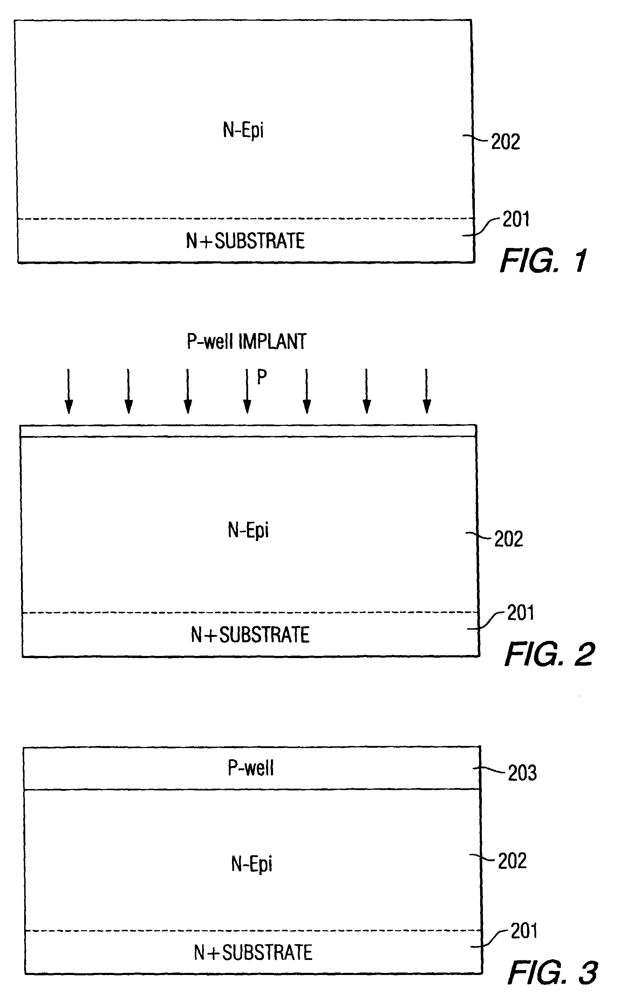

FIG. 16 shows a device 200; the steps in its formation are illustrated by FIGS. 1-16.

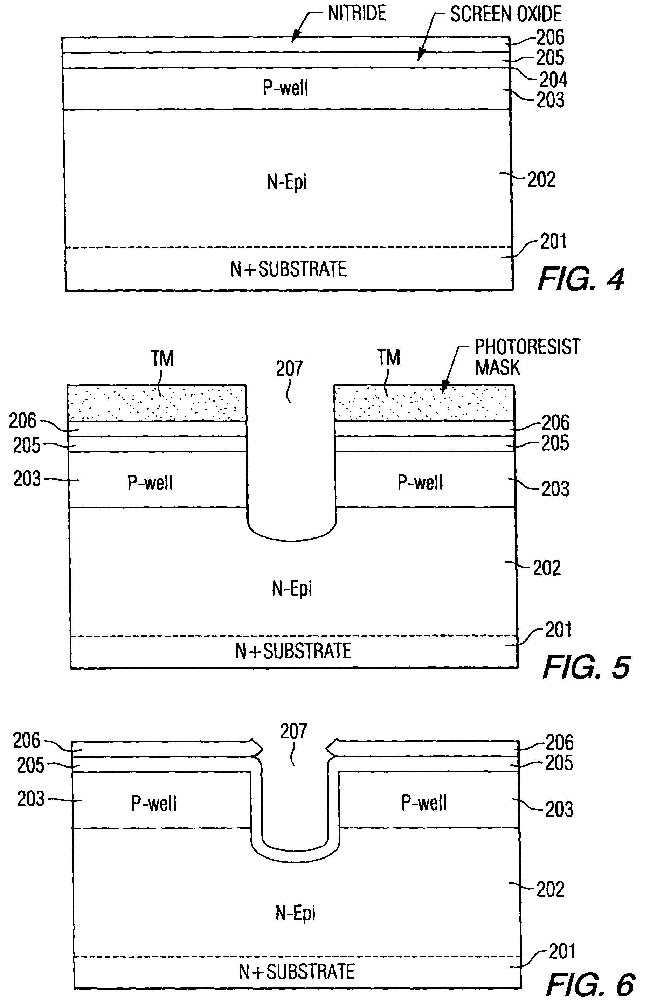

As shown in FIGS. 1-3, a highly doped substrate 201 having a doped upper layer 202, both shown as being of N conduction type, is implanted with a dopant, shown as a P conduction type, which is thermally driven to form a P-well region 203. Although upper layer 202 and well region are shown as being of N and P, respectively, conduction types, it is recognized that the conduction types of these elements can be reversed . Substrate 201 can be monocrystalline silicon, and upper layer 201 can be an epitaxial layer having the thickness and resistivity characteristics needed for a desired breakdown voltage. Alternatively, upper layer 202 can be included within substrate 201. On the upper surface 204 of layer 202 is deposited a stack comprising an optional screen oxide layer 205 and a nitride layer 206, as shown in FIG. 4.

A photoresist trench mask TM is formed, and oxide layer 205 and nitride layer 206 are selectively etched to produce a trench 207 extending into layer 202 to a depth below that of P-well region 203, as depicted in FIG. 5. Trench 207 can have a width of, for example, about 0.8 µm to about 0.9 µm and a depth of about 0.5 µm to about 4 µm.

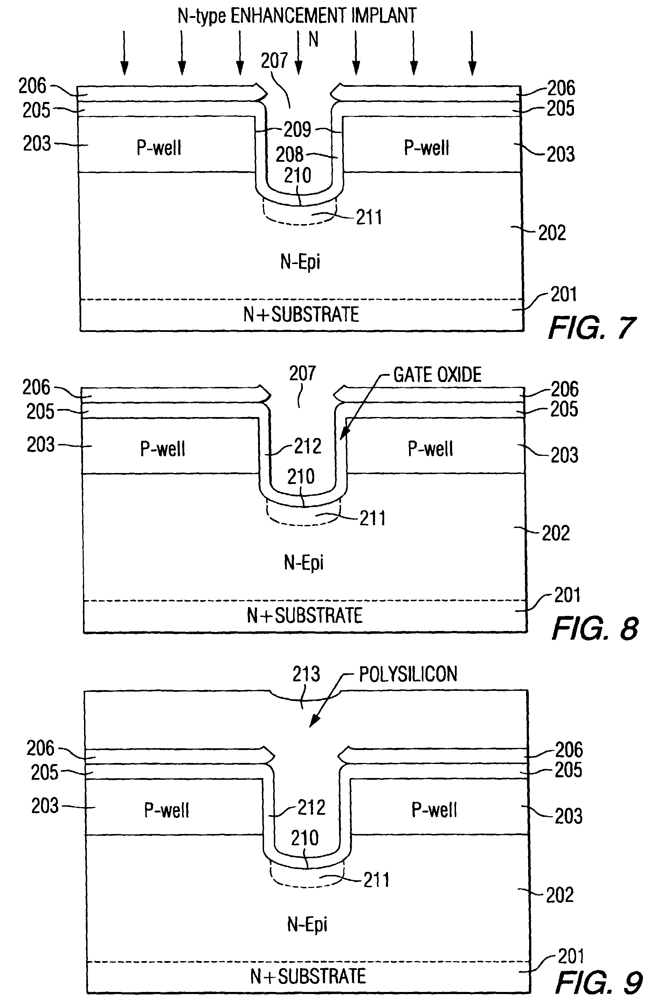

As shown in FIG. 6, a thin layer of oxide 208, whose thickness can be about 500 angstroms to about 2000 angstroms, is thermally grown on the sidewalls 209 and floor 210 of trench 207. An N-type dopant is implanted through the oxide layer 208 on trench floor 210 at, for example, a concentration of about le12 to 5e12 at an energy of about 20 KeV to 200 KeV to produce an enhanced conductivity drain region 211, which is located below and self-aligned to trench floor 210, as shown in FIG. 7. The remaining oxide 208 inside trench 207 is removed using a non-selective etching technique such as a wet oxide etch.

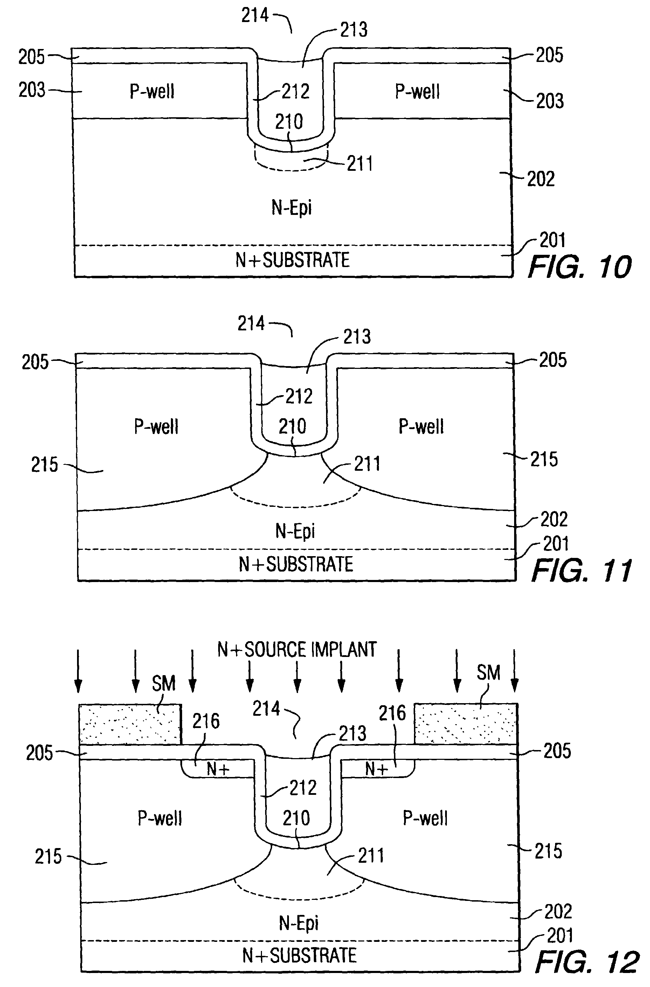

As depicted in FIGS. 8 and 9, a gate insulating layer 212 of, for example, silicon dioxide is formed on the floor and sidewalls of french 207, and a thick layer of a conductive material 213 such as highly doped polysilicon is formed in trench 207. Conductive material 213 is planarized to expose nitride layer 206, which is removed by etching. The conductive material 213 in the trench is etched, optionally to a point slightly beneath the surface of the wafer, to form a trench gate 214, as shown in FIG. 10.

A deep P-well region 215 is formed in upper layer 202 by high temperature diffusion of P-well region 203, as depicted in FIG.11. The depth of deep P-well region 215 is dependent on the thermal budget used. However, because it abuts the enhanced conductivity drain region 211, near trench gate 214, the deep P-well region 215 does not extend to a depth where it completely encompasses trench floor 210.

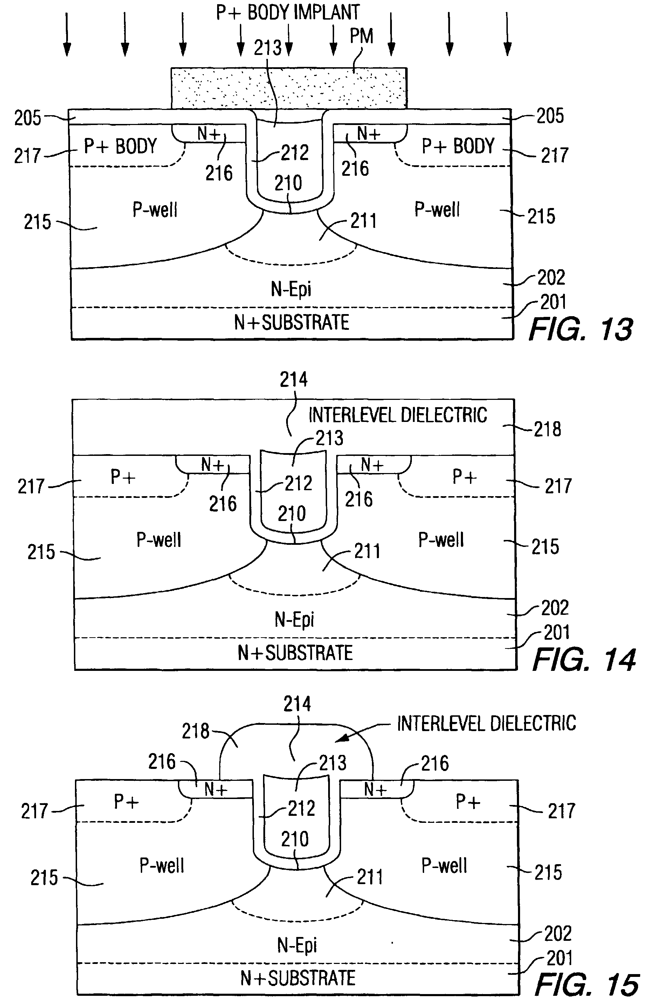

Using a photoresist mask SM, an N+ source region 216 is formed by selective implantation in upper layer 202, as shown in FIG. 12. Following removal of mask SM, a P+ body region 217 is formed by selective implantation using body mask PM, as depicted in FIG. 13. Mask PM is removed, and an interlevel dielectric layer 218 is deposited and densified, as shown in FIG. 14. The densification conditions also serve to activate the dopants in the N+ source and P+ body regions. Suitable N+, i.e., first conduction type, dopants include arsenic and phosphorus. Boron is a useful P+, i.e., second conduction type, dopant. Interlevel dielectric 218, which can be borophosphosilicate glass (BPSG) or phosphosilicate glass (PSG), is patterned by photoresist masking (not shown) to expose body and source contact regions 219 and 220, respectively, as shown in FIG. 15. Metal contact layer 221 is then deposited on contact regions 219 and 220 to form device 200 of the invention, depicted in FIG. 16. A drain metal layer (not shown) is formed on the back side of device 200.

In device 200, the deep P-well region 215 is deeper than trench gate 214, and the drain region 211 directly below gate 214 is conductivity enhanced. The self-alignment method is used to create both regions is advantageous for reducing cell size. The purpose of the deep well region 215 is to decrease the maximum electric field in the trench corners 221. The depletion layer formed during the device off-state reaches deeper into the drain side and further away from the gate oxide/drain interface 222, resulting in shielding of gate oxide/drain silicon interface 222 and, in effect reducing the electric field at the interface.

The enhanced conductivity drain region 211 located between deep P-well/P+ body regions 215/217 directly under gate trench 214 has two benefits, the first being to provide self alignment for deep P-well/ P+body formation, which prevents it from encroaching too far into the upper drain region. If the deep P-well region 215 is not used together with the enhanced conductivity drain region 211, the control of trench depth becomes critical and prevents deeper well diffusion. In the MOSFET on-state, applying a positive bias to the gate with respect to the source electrode causes a thin channel to be formed, allowing current to flow from the drain to the source electrode. Current flowing through the drain into the thin channel is significantly choked off, causing device on-resistance to become high and variable.

The second benefit of the enhanced conductivity drain region 211 is to lower the device on-resistance. Current pinching (crowding) is present in the upper drain region causes the device on-resistance to be significantly increased. By enhancing the conductivity of this critical region, the resistance encountered by the current is decreased, preventing additional loss due to current crowding.

Computer simulations (FIGS. 18 and 19) show the electric field strength along cross sections A-A of FIGS. 16 and 17 for, respectively, the prior art device 100 and the device 200 of the present invention. There is a 30% reduction in the electric field at the center (zero distance on the graphs) of the trench floor for device 200 versus device 100, where device 200 has the well diffused 0.8 µm deeper than the trench. The improvement is even greater at the corners 221 of the trench floor, where the electric field is highest in the prior art device, because corners 221 lie within the deep P-well regions 215. Additional benefits provided by device 200 of the present invention relative to prior art device 100 are reductions in Miller capacitance and switching loss, which result from the reduced drain area under the gate oxide.

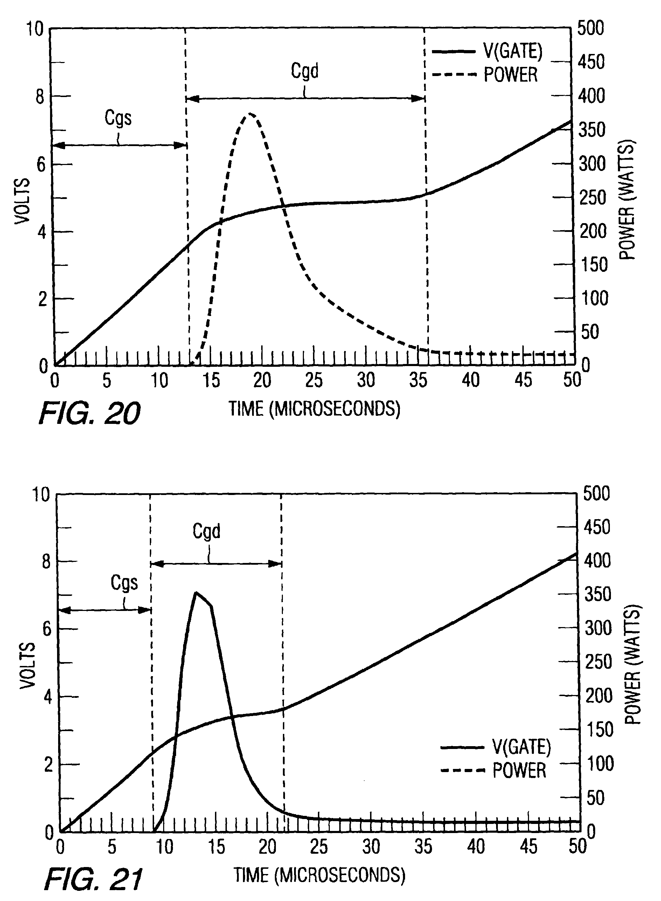

FIGS. 20 and 21 are computer-simulated switching power loss and gate charge curves for, respectively, the devices 100 and 200 of the prior art and the present invention. From the curves, it can be calculated that the device of the invention exhibits approximately a 2X improvement in gate-drain capacitance C_{g-d} over the prior art, which directly translates to about a 40 % decrease in power loss during switching.

The trench MOS-gated device of the present invention, compared to devices of the prior art, provides improved breakdown voltage reliability and reduced switching loss and, thereby, increased power handling and efficiency. These improvements result from the shielding of the electric field during the device off-state by a deep well/body diffusion to a position below the floor of the trench. The enhanced conductivity drain region 211 below the french floor allows for a sell aligned process to create the deep well region 215, resulting in a reduction in device on-resistance in the region where current crowding occurs.

A power trench MOS-gated device includes a heavily doped semiconductor substrate, a doped upper layer of a first conduction type on the substrate, and a trench gate in the upper layer that comprises a conductive material separated from the upper layer by an insulating layer. An enhanced conductivity drain region underlies the trench gate, and a heavily doped source region of the first conduction type and a heavily doped body region of a second and opposite conduction type are disposed at an upper surface of the upper layer. A deep well region of the second conduction type underlies the source and body regions and extends below the trench gate and abuts the enhanced conductivity drain region. A process for forming a power trench MOS-gated device comprises providing a semiconductor substrate having a doped upper layer of a first conduction type. A dopant of a second and opposite conduction type is implanted into an upper surface of the upper layer, thereby forming a well region in the upper layer, and a layer of nitride is deposited on the upper surface. The nitride layer and upper layer are selectively etched to form a trench in the upper layer. The sidewalls and floor of the trench are lined with a thin insulating layer, and a dopant of the first conduction type is implanted through the thin insulating layer on the trench floor, to forming an enhanced conductivity drain region in the upper layer underlying the trench floor. The thin insulating layer is removed from the trench, and a layer of gate insulating material is formed on the sidewalls and floors of the trench, which is then substantially filled with a conductive material to form a trench gate. The nitride layer is removed from the upper surface of the upper layer, and the well region in the upper layer is thermally diffused, thereby forming a deep well region in the upper layer.

## Claims

1. A power trench MOS-gated device comprising a heavily doped semiconductor substrate, a doped upper Layer of a first conduction type disposed on said substrate, a trench gate disposed in said upper layer, said gate comprising a conductive material separated from said upper layer by an insulating layer, an enhanced conductivity drain region underlying said trench gate in said upper layer, characterized in that a heavily doped source region of said first conduction type and a heavily doped body region of a second and opposite conduction type disposed at an upper surface of said upper layer, a deep well region of said second conduction type disposed in said upper layer underlying said source and body regions, said deep well region extending below said trench gate and abutting said enhanced conductivity drain region, in which said enhanced conductivity drain region is more heavily doped than said doped upper layer.

2. A device as claimed in claim 1 further comprising an overlying metal contact to said source region and said body region, said upper layer is included within said substrate, and said upper layer comprises an epitaxial layer.

3. A device as claimed in claim 1 wherein said first conduction type is N and said second conduction type is P, said substrate comprises monocrystalline silicon and said insulating layer comprises silicon dioxide, and said conductive material in said trench gate comprises highly doped polysilicon, in which said interlevel dielectric material is borophosphosilicate glass or phosphosilicate glass, and the device is selected from the group consisting of a power MOSFET, an insulated gate bipolar transistor, and an MOS-controlled thyristor.

4. A process for forming a power trench MOS-gated device, said process comprising providing a semiconductor substrate comprising a doped upper layer of a first conduction type, said upper layer having an upper surface, implanting a dopant of a second and opposite conduction type into said upper surface, so as to form a well region in said upper layer, forming a layer of nitride on said upper surface of said upper layer, selectively etching said nitride layer and said upper layer, so as to form a trench in said upper layer, lining sidewalls and floor of said trench with a thin insulating layer, characterized by implanting a dopant of said first conduction type through the trench floor, so as to form an enhanced conductivity drain region underlying said trench floor, removing said thin insulating layer from said trench, forming a layer of gate insulating material on the sidewalls and floors of the trench, then substantially filling said trench with a conductive material, to form a trench gate, removing said nitride layer from said upper surface of said upper layer, thermally diffusing said well region in said upper layer, to form a deep well region in said upper layer, said deep well region extending below said french gate and abutting said enhanced conductivity drain region, selectively implanting a dopant of said first conduction type into said upper layer, thereby forming a heavily doped source region adjacent to said gate trench, and selectively implanting a dopant of said second conduction type into said upper layer, to form a heavily doped body region adjacent to said source region.

5. A process as claimed in claim 4 characterized by forming a layer of interlevel dielectric material on said trench gate and said upper surface of said upper layer, selectively etching said interlevel dielectric layer, thereby forming a source region contact area and a body region contact area, forming a metal contact on said source region contact area and on said body region contact area, forming a screen layer of oxide on said upper surface of said upper layer prior to forming said nitride layer, in which said upper layer is included within said substrate, and said upper layer comprises an epitaxial layer.

6. A process as claimed in claim 4 wherein said first conduction type is N and said second conduction type is P, said substrate comprises monocrystalline silicon and said insulating layer comprises silicon dioxide, said conductive material in said trench gate comprises highly doped polysilicon.

7. A process as claimed in claim 4 wherein said dopant of a first conduction type comprises arsenic or phosphorus, said dopant of a second conduction type comprises boron, in which said interlevel dielectric material comprises borophosphosilicate glass or phosphosilicate glass, and the device is selected from the group consisting of a power MOSFET, an insulated gate bipolar transistor, and an MOS-controlled thyristor.

8. A process for forming a power trench MOS-gated device including the steps of forming a gate trench in a doped upper layer of a first conduction type disposed on a substrate, implanting dopants of first and second, opposite conduction types into the upper layer to form, respectively, a source region and a body region in said upper layer, characterized by increasing the doping of a portion of said upper layer proximate the floor of the gate trench, so as to form an enhanced conductivity drain region of said first conduction type underlying said trench floor, forming a deep well region of said second conduction type in said upper layer, said deep well region extending below said trench gate and abutting said enhanced conductivity drain region, forming a layer of interlevel dielectric material on said trench gate and on an upper surface of said upper layer, selectively etching said interlevel dielectric layer, so as to form a source region contact area and a body region contact area, and forming metal contacts on said source and body region contact areas.

9. A process as claimed in claim 8 wherein said upper layer is included in a substrate comprising monocrystalline silicon, said substrate comprises monocrystalline silicon and said upper layer comprises an epitaxial layer of silicon, said first conduction type is N and said second conduction type is P, in which said interlevel dielectric material comprises borophosphosilicate glass or phosphosilicate glass, and said device is selected from the group consisting of a power MOSFET, an insulated gate bipolar transistor, and an MOS-controlled thyristor.
